# EUROPÄISCHE PATENTSCHRIFT

(11) **EP 1 644 959 B1**
(45) Veröffentlichungstag und Bekanntmachung des Hinweises auf die Patenterteilung: **11.09.2013**
(21) Anmeldenummer: 04738069.6
(22) Anmeldetag: 08.07.2004
(51) Int. Cl.: H01L 21/677

(54) **VORRICHTUNG ZUM LAGERN UND/ODER TRANSPORTIEREN VON PLATTENFÖRMIGEN SUBSTRATEN IN DER FERTIGUNG VON ELEKTRONISCHEN BAUTEILEN**
DEVICE FOR STORING AND/OR TRANSPORTING PLATE-SHAPED SUBSTRATES IN THE MANUFACTURE OF ELECTRONIC COMPONENTS
DISPOSITIF POUR STOCKER ET/OU TRANSPORTER DES SUPPORTS EN FORME DE DISQUES DANS LA FABRICATION D'ELEMENTS ELECTRONIQUES

(30) Priorität: 11.07.2003 CH 12192003; 16.02.2004 CH 2372004
(43) Veröffentlichungstag der Anmeldung: 12.04.2006
(73) Patentinhaber: Tec-Sem AG, 8274 Tägerwilen (CH)
(72) Erfinder: BLATTNER, Jakob, CH-8272 Ermatingen (CH); FEDERICI, Rudy, CH-8572 Berg (TG) (CH)
(74) Vertreter: Klein, Friedrich Jürgen
(86) Internationale Anmeldenummer: PCT/CH2004/000428
(87) Internationale Veröffentlichungsnummer: WO 2005/006407

(56) Entgegenhaltungen:
- WO-A-97/20341
- JP-A- 2001 291 759
- US-A- 5 534 074
- US-A- 5 752 609
- US-A1- 2002 018 703
- PATENT ABSTRACTS OF JAPAN Bd. 2003, Nr. 11, 5. November 2003 (2003-11-05) -& JP 2003 188243 A (SUMITOMO MITSUBISHI SILICON CORP; MITSUI ENG & SHIPBUILD CO LTD; SHINK), 4. Juli 2003 (2003-07-04)
- PATENT ABSTRACTS OF JAPAN Bd. 2002, Nr. 08, 5. August 2002 (2002-08-05) -& JP 2002 110577 A (SONY CORP), 12. April 2002 (2002-04-12)

## Beschreibung

Die vorliegende Erfindung betrifft eine Vorrichtung gemäß dem Anspruch 1 zum Lagern von plattenförmigen, insbesondere scheibenförmigen, Substraten, wie sie in der Fertigung von elektronischen Bauteilen üblich sind. Derartige Substrate können insbesondere sogenannte Wafer oder Testwafer sein. Mit einer erfindungsgemässen Vorrichtungen können insbesondere mehrere Substrate vorzugsweise horizontal gelagert werden. Ausserdem betrifft die Erfindung ein Verfahren gemäß dem Anspruch 17 zur Handhabung von solchen Substraten im Zusammenhang mit deren Lagerung.

Elektronische Bauteile werden üblicherweise aus etwa kreisförmigen Halbleiterscheiben, sogenannten Wafern, erzeugt. Diese Substrate müssen verschiedenen Prozessanlagen zugeführt werden, in denen die Substrate im wesentlichen Oberflächen behandelt werden. In diesem Zusammenhang ist es oftmals erforderlich, die Substrate zwischen zu lagern, wenn nach Abschluss der Prozessierung in einer Prozessanlage die Substrate nicht unmittelbar folgend einer anderen Prozessanlage zugeführt werden können. Es ist üblich, die Substrate dann in einer Speichervorrichtung unter Rein- bzw. Reinstraumbedingungen (nachfolgend insgesamt "Reinraumbedingungen" genannt) zwischen zu lagern. Da die Kosten zur Erzeugung von Reinraumbedingungen im wesentlichen von der Grösse des Raumes abhängig sind, wird in der Regel angestrebt, die Substrate mit möglichst geringem Abstand zueinander zu lagern.

Trotz des möglichst geringen Abstandes zueinander ist es oftmals erforderlich bestimmte einzelne Wafer aus der Lagervorrichtung entnehmen zu können, ohne hierbei andere Substrate zu entnehmen. Der Abstand aufeinander folgender Substrate innerhalb solchen Lagervorrichtungen wird deshalb dadurch begrenzt, dass noch ein Zugriffsabstand vorhanden ist, in den ein Greifer einführbar ist, um das entsprechende Substrat zu erfassen und zu entnehmen.

Um Prozessierungsvorgänge optimieren zu können, werden sogenannte Testwafer verwendet. Aus solchen Testwafern werden in der Regel keine elektronischen Bauteile gefertigt. Sie dienen lediglich dazu auf empirische Weise Prozessparameter zu optimieren, indem Testwafer mit unterschiedlichen Prozessparametern prozessiert werden und nachfolgend anhand von Messungen ermittelt wird, welche Werte der Prozessparameter bei den eigentlich zu prozessierenden Wafern verwendet werden. Ausser den erwähnten Wafern sind auch derartige Testwafer ein weiteres bedeutsames Anwendungsgebiet für die vorliegende Erfindung.

Des Weiteren kann es erforderlich sein, Wafer innerhalb oder auch ausserhalb einer Fabrik in einem Behältnis zu transportieren. Auch hierfür werden Transportbehälter eingesetzt, die mehrere Lagerungselemente aufweisen, auf denen jeweils in der Regel ein Substrat angeordnet werden kann. Derartige Transportbehälter sind oftmals genormt, beispielsweise als sogenannte FOUP-Transportboxen. Auch hier besteht das Bedürfnis die Substrate mit möglichst geringem Abstand zueinander anordnen zu können.

Aus der JP2003-188243A ist ein Bearbeitungsofen bekannt, in den mehrere Wafer eingebracht und durch Erhitzung behandelt werden können. Die JP2003-188243A beschreibt hierbei eine Lösung für das Problem eines bei Erhitzen der Wafer eintretenden Rutschens der Wafer auf einer Kontaktfläche einer Auflage. In der JP2003-188243A wird hierzu ein Wafer-Lagerelement vorgeschlagen, das einen scheibenförmigen Stützkörper aufweist, von dem aus bogenförmige Erhebungen nach oben abstehen. Das Rutschen auf einer Auflagerfläche der Erhebungen soll durch einen mit einem Radius versehenen Übergang der Auflagerfläche in die vom scheibenförmigen Stützkörper abstehende bogenförmige Erhebung verhindert werden.

In der JP2002-110577A wird ebenfalls eine Heizvorrichtung für Wafer beschrieben. Durch die in der JP2002-110577A beschriebene Lösung soll eine positionsgenaue Übergabe von Wafer durch eine Transfervorrichtung ermöglicht werden. Hierzu soll eine Lagervorrichtung mehrere Pfosten aufweisen, in die Nuten eingebracht sind. Mehrere auf gleicher vertikaler Höhe angeordnete Nuten der Pfosten ergeben gemeinsam ein Auflager für einen Wafer. Die Wafer liegen hierbei mit ihrer Unterseite auf Halteflächen der Nuten auf, die zudem eine obere Nicht-Haltefläche aufweisen, die mit den Wafern nicht in Kontakt ist. In radialer Richtung werden die Nuten durch Gegenflächen begrenzt. Um die Übergabegenauigkeit zu erhöhen soll eine Positionslernnut vorgesehen sein, deren Stirnseite eine von den Positionen der Gegenflächen anderer Nuten sich unterscheidende Position aufweist und die als Referenzfläche beim Teach-in der Positionsdaten der Wafer verwendet wird.

In der US 2002/0018703 A1 ist ein Waferkassettenmechanismus beschrieben, bei dem jeweils paarweise vorhandene und als Lagerungselemente zusammenwirkende, sich seitlich jeweils längserstreckende Ablagen, vorgesehen sind. Die Ablagen weisen eine in horizontaler Richtung zur jeweils gegenüberliegenden Ablage weisende Vorsprung auf, dessen Höhe geringer ist als die Höhe der Ablage. Die Wafer werden auf den Vorsprüngen der jeweils paarweise zusammenwirkenden und zu bewegenden Ablagen angeordnet.

Aus der JP2001-291758A ist ein "Pitch transfer apparatus" vorbekannt, mit dem der Pitchabstand von Objekten in einem Stapel von Objekten variiert werden soll. Die in der JP2001-291759A beschriebene Vorrichtung weist für jedes Objekt ein Paar von sich jeweils gegenüberliegenden und nicht miteinander in Kontakt stehenden Halteplatten auf, von denen aus Vorsprünge in Richtung auf die jeweils gegenüberliegende Halteplatte abstehen, wobei die Vorsprünge in Art einer geradlinig verlaufenden Leiste ausgebildet sind. Die Objekte sollen auf den Vorsprüngen der jeweils paarweise angeordneten Halteplatten aufliegen. Um den Pitchabstand der Objekte zu varrieren, werden die sich jeweils gegenüberliegenden Halteplatten mittels zweier voneinander getrennter Bewegungen in vertikaler Richtung bewegt.

In der US 5,752,609 ist eine Prozessierungsanlage beschrieben, bei der Wafer in einer Wärmebehandlungskammer angeordnet werden. Durch Einleiten von bestimmten Gasen in die Wärmebehandlungskammer sollen Dünnschichten auf den Wafern erzeugt werden. Durch die in dieser Schrift beschriebenen Maßnahmen soll eine besonders gleichmäßiger Strömung dieser Gase über die Waferöberflächen erreicht werden. Die Wafer werden hierzu zunächst ausserhalb der Wärmebehandlungskammer in ein sogenanntes Wafer Boat eingesetzt, so dass die Wafer mit Abstand und horizontal parallel zueinander ausgerichtet sind. Zur Anordnung der Wafer im Wafer Boat weist letzteres mehrere mit vorbestimmten und unveränderlichen Abstand zueinander angeordnete Ringe auf, deren Innendurchmesser grösser als der Außendurchmesser der darauf anzuordnenden Wafer sein kann. Zur Aufnahme von jeweils einem Wafer weist jeder Ring drei mit Abstand zueinander am Umfang des jeweiligen Rings angeordnete Stützstücke 64a-64c auf, die nach oben und innen vom jeweiligen Ring abstehen. Die Ringe werden von mehreren senkrecht ausgerichteten und um einen Teil des Umfangs der Ringe verteilt angeordneten Stangen gehalten. Der unverändediche Abstand der einzelnen Ringe zueinander beträgt ein Vielfaches der Waferdicke. Damit Wafer aus dem Wafer Boat entnommen werden können sind die Stangen nur höchstens entlang eines Halbkreises des Umfangs der Ringe angeordnet. An der somit zumindest halbkreisförmigen anderen Seite des Wafer Boats befinden sich keine Stangen, wodurch hier ein Einsetzen und eine Entnahme von Wafern erfolgen kann.

Der Erfindung liegt deshalb die Aufgabe zugrunde, eine Vorrichtung zu schaffen, mit der mehrere, vorzugsweise horizontal gelagerte Substrate, mit möglichst geringem Abstand zueinander gelagert und gegebenenfalls transportiert werden können. Zumindest in bevorzugten Weiterbildungen sollen zudem auf möglichst einfache Weise auch innerhalb der Vorrichtung Reinraumbedingungen geschaffen werden können. Gemäss einem weiteren Aspekt der Erfindung soll ein Werkzeug bereitgestellt werden, mit dem Substrate trotz ihres möglichst geringen Abstandes zueinander aus der Vorrichtung entnommen werden können. Noch ein weiterer Aspekt der Erfindung betrifft ein Verfahren zum Einordnen oder Herausnehmen von Substraten aus der Vorrichtung.

Die Aufgabe wird durch eine Vorrichtung gelöst, wie sie in Anspruch 1 wiedergegeben ist. Besonders vorteilhaft ist hierbei, wenn zwischen einer Vielzahl, vorzugsweise zwischen sämtlichen, jeweils aufeinander folgenden Lagerungselementen ihr jeweiliger Abstand von einem Lagerungsabstand zu einem hierzu vergrösserten Zugriffsabstand veränderbar ist. Dies hat zur Folge, dass im Lagerungszustand ein möglichst geringer sogenannter Pitchabstand zwischen aufeinander folgenden Lagerungselementen und damit auch Substraten erzielbar ist. Der Lagerungsabstand wird im wesentlichen nur durch einen Mindestabstand begrenzt, der eingehalten werden sollte, um sicherzustellen, dass sich die Oberflächen der Substrate nicht berühren. Mit der Erfindung sind daher sehr hoch verdichtete Lagerungen von Wafern oder anderen Substraten möglich. Trotzdem ermöglicht die Erfindung den Vorteil, auf jedes der in der geschlossenen Lagerung enthaltenen Substrat einzeln zugreifen zu können.

In einer bevorzugten Ausführungsform der Erfindung kann bei sämtlichen der vorhandenen aufeinanderfolgenden Lagerelementen ihr Abstand zueinander zu Zugriffszwecken verändert werden. Damit kann auf jedes in der Vorrichtung gelagerte Substrat einzeln zugegriffen werden. Die Vergrösserung des Abstandes erfolgt vorzugsweise parallel zur Stapelrichtung der Lagerungselemente. Grundsätzlich können erfindungsgemässe Vorrichtungen konstruktiv ausgelegt sein, um Substrate in einer horizontalen oder in einer vertikalen Ausrichtung oder in beliebigen Ausrichtungen dazwischen zu lagern.

Im Zusammenhang mit der Erfindung kann es zweckmässig sein, die zur Vergrösserung des Abstandes von zwei aufeinander folgenden Lagerungselementen erforderliche Relativbewegung dadurch zu erzielen, dass das bei einer horizontalen Ausrichtung der Substrate obere Lagerungselemente angehoben werden. In Abhängigkeit der Lagerungsabstände der Lagerungselemente kann es hierbei erforderlich sein einige oder sämtliche darüber befindliche Lagerungselemente mit anzuheben.

In einer anderen Ausgestaltung wird die Vergrösserung des Lagerabstandes hin zum Zugriffsabstand dadurch erreicht, dass das untere der beiden voneinander zu trennenden Lagerungselemente nach unten bewegt wird. Auch hier kann es erforderlich sein, einige oder sämtliche auf das untere der beiden Lagerungselemente (zwischen denen ein Zugriffsabstand erzielt werden soll) folgenden Lagerungselemente ebenfalls nach unten zu bewegen.

Schliesslich kann auch in einer weiteren alternativen Ausführungsform das untere der beiden gegeneinander zu beabstandenden Lagerungselementen nach unten und das obere Lagerungselement nach oben bewegt werden. Im Zusammenhang mit der Erfindung sind somit eine Vielzahl von Varianten von Relativbewegungen denkbar, um Lagerungselemente voneinander zu trennen und einen Zugriff auf einen Lagerungsbereich von zumindest einem der Lagerungselemente zu ermöglichen.

Eine besonders vorteilhafte erfindungsgemässe Ausgestaltung lässt sich durch Lagerungselemente erzielen, die unmittelbar aufeinander angeordnet sind. Die Lagerungselemente können dabei ringförmig geschlossen sein und jeweils mehrere Auflager aufweisen, auf denen jeweils ein Substrate angeordnet werden kann. Die Auflager können beispielsweise gegenüber den zumindest etwa runden Ringen nach oben abgewinkelt sein und Auflageflächen zur Auflagerung eines Substrates aufweisen.

Hierdurch ist es auch möglich, das Gehäuse der Vorrichtung durch die Lagerungselemente selbst auszubilden. Innerhalb des Gehäuses können Reinraumbedingungen erzeugt und aufrecht erhalten werden. Mit einer solchen Ausgestaltung kann ein sonst erforderliches zusätzliches Gehäuse vermieden werden. Des Weiteren lässt sich damit auch das Problem einer sonst ebenfalls erforderlichen Zugriffsöffnung im Gehäuse und die Positionierung des zu entnehmenden bzw. einzuführenden Substrates vor der Zugriffsöffnung auf günstige Weise vermeiden. Trotzdem kann es in bestimmten Ausführungsformen der Erfindung auch zweckmäsig sein, um die Lagerungselemente herum ein Gehäuse anzuordnen, das mit einer Einführ-/Entnahmeöffnung für Substrate und/oder Lagerungselemente versehen sein kann.

Es ist hierbei besonders bevorzugt, wenn die Lagerungselemente einzeln aus dem Stapel von Lagerungselementen entnommen oder eingefügt werden können. Besondere Vorteile lassen sich dann erzielen, wenn ein Lagerungselement an einer beliebigen Stelle des Stapels entnommen oder eingefügt werden kann, ohne dass zuvor oder danach zu diesem Zweck andere Lagerungselemente bewegt werden müssen. Dies kann beispielsweise dazu dienen, ein Lagerungselement gegen ein anderes Lagerungselement auszutauschen, ein Substrat zusammen mit seinem Lagerungselement zu transportieren, oder auch um einen Stapel zu verkleinern oder zu vergrössern. Hierdurch kann mit sehr geringem Aufwand auch die Lagerungskapazität den jeweiligen Bedingungen angepasst werden. Um dies zu erreichen kann es zweckmässig sein, wenn die Lagerungselemente aufeinander stapelbar sind, ohne dass sie eine lösbare oder unlösbare Verbindung zueinander aufweisen.

Mit einer solchen Lösung bietet sich auch die Möglichkeit, ein Substrat zusammen mit seinem Lagerungselement aus dem Stapel zu entnehmen und innerhalb einer Prozessanlage oder einer Fabrik zu transportieren. Hierdurch lässt sich die Anzahl der erforderlichen Kontakte zwischen Handhabungseinrichtungen und dem jeweiligen Substrat selbst erheblich reduzieren. Derartige Kontakte bergen stets die Gefahr in sich, dass das jeweilige Substrats beschädigt wird.

Um das Gehäuse nach aussen abzudichten, können Lagerungsringe mit Dichtungselementen versehen sein, die dann einen möglichen Spalt zwischen den Lagerungselementen abdichten, wenn diese den vorgesehenen Lagerungsabstand zueinander einnehmen. Die hierdurch erzielbare vorteilhafte Einkapselung der Vorrichtung gegen aussen lässt sich auch durch andere Dichtungsmittel erzielen.

Der durch eine Vielzahl von übereinander angeordneten Lagerelementen entstehende Turm bzw. Stapel kann insbesondere bei der Erzeugung eines Zugriffsabstandes zwischen zwei Lagerungselementen zur Instabilität neigen. Um dies zu vermeiden kann die Vorrichtung mit Stabilisierungselementen versehen sein. Solche Stabilisierungselemente können beispielsweise Zentrierungselemente sein, die an den Lagerungselementen angebracht sind und die Lagerungselemente gegeneinander exakt ausrichten. Eine andere Möglichkeit sind seitliche Führungselemente, die aussen neben den Lagerelementen angeordnet sind und die ein Kippen des Turms verhindern.

Gemäss einem weiteren Aspekt der Erfindung kann mit ihr auch eine Transportvorrichtung ausgebildet werden, mit der sich mehrere Substrate gleichzeitig auf vergleichsweise geringem Raum transportieren lassen. Aufgrund den bereits erwähnten Eigenschaften der Erfindung lassen sich mit solchen erfindungsgemässen Transportvorrichtungen bei gleicher Transportkapazität deutlich kompaktere Transportbehälter realisieren, als die eingangs bereits erwähnten heute üblichen FOUP-Boxen.

Die mit der Erfindung erzielbare extrem hochverdichtete Lagerung der Substrate ist insbesondere im Zusammenhang mit Transportvorrichtungen von Vorteil, die zum Transport ausserhalb einer Fabrik vorgesehen sind, da die Kosten und der technische Aufwand für einen Transport mit der Grösse des Transportbehälters zunehmen. Aber auch innerhalb einer Fabrik kann die Anwendung solcher kompakter Transportboxen bzw. Transportboxen, die bei gleichen Abmessungen wie bisher eine deutlich höhere Aufnahmekapazität für Substrate aufweisen, von grossem Vorteil sein. In diesem Zusammenhang kann auch ein Transportbehälter von Vorteil sein, in dem lediglich ein Lagerungselement mit seinem Substrat aufgenommen werden kann. Ein erfindungsgemässes Lagerungselement kann mit oder ohne Transportbehälter zum Transport innerhalb einer Fabrik auf einem Förderband oder einer sonstigen Fördereinrichtung vorgesehen sein.

Weitere vorteilhafte Ausgestaltungen ergeben sich aus den Ansprüchen, der Beschreibung und der Zeichnung.

Die Erfindung wird anhand den in den Figuren rein schematisch dargestellten Ausführungsbeispielen näher erläutert; es zeigen:
- Fig. 1: eine Ansicht einer erfindungsgemässen Vorrichtung von der Seite;
- Fig. 2: eine Detaildarstellung aus Fig. 1;
- Fig. 3: eine Detaildarstellung aus Fig. 1 von oben;
- Fig. 4: eine Darstellung der Vorrichtung gemäss Figur 1 von oben;
- Fig.5a-d: einen Ablauf der Öffnung der Vorrichtung zur Entnahme oder zur Einordnung einer Waferscheibe;
- Fig 6: eine schematische Ablaufzeichnung mit Elementen der erfindungsgemässen Vorrichtung und eines efindungsgemässen Werkzeuges;
- Fig.7: eine Gesamtdarstellung einer Speichervorrichtung gemäss einer bevorzugten Ausführungsform der Erfindung;
- Fig. 8: eine Detaildarstellung der erfindungsgemässen Vorrichtung gemäss des Ausführungsbeispiels nach Fig. 7;
- Fig. 9: eine perspektivische Detaildarstellung gemäss Fig. 8;
- Fig. 10: eine Darstellung der eingebauten Vorrichtung gemäss Fig. 7 von oben;
- Fig. 12: eine Detaildarstellung gemäss Fig. 10;
- Fig. 13: eine perspektivische Darstellung eines Lagerungsrings gemäss des Ausführungsbeispiels nach Fig. 7;
- Fig. 14: eine Ansicht von oben auf den Lagerungsring nach Fig. 13;
- Fig. 15: eine Seitenansicht des Lagerungsrings nach Fig. 13;
- Fig. 16: eine Detaildarstellung nach Fig. 15 mit aufgelegter Waferscheibe;
- Fig. 17: eine Darstellung der Führungselemente von oben gemäss der Ausführung nach Fig. 7;
- Fig. 18: eine perspektivische Darstellung gemäss Fig. 17;
- Fig. 19: eine Seitenansicht gemäss Fig. 17;
- Fig. 20-23: einen Ablauf eines Anhebens der oberen Lagerungsringe, Freistellen des zu bearbeitenden Lagerungsringes und Herunterhaltens der darunter liegenden Lagerungsringe mit dem Werkzeug (jeweils ohne Darstellung der Lagerungsringe);
- Fig. 24-28: den Vorgang des Anhebens der oberen Lagerungsringe, Freistellen des zu bearbeitenden Lagerungsringes und Herunterhaltens der darunter liegenden Lagerungsringe mit dem Werkzeug (jeweils mit Darstellung der Lagerungsringe);
- Fig. 29: ein weiteres Ausführungsbeispiel der erfindungsgemässen Vorrichtung in einer perspektivischen Darstellung ;
- Fig. 30: ein Stapel aus Fig. 29 mit erfindungsgemässen Lagerungselementen;
- Fig.31,32: zwei unterschiedliche Zustände während einer Trennung von Lagerungselementen für einen Zugriff;
- Fig. 33: eine perspektivische Darstellung eines Stapels in einem Zugriffzustand;
- Fig. 34: eine perspektivische Detaildarstellung eines Lagerungsrings mit einem darauf angeordnetem Wafer;
- Fig. 35: ein erfindungsgemässer Transportbehälter.

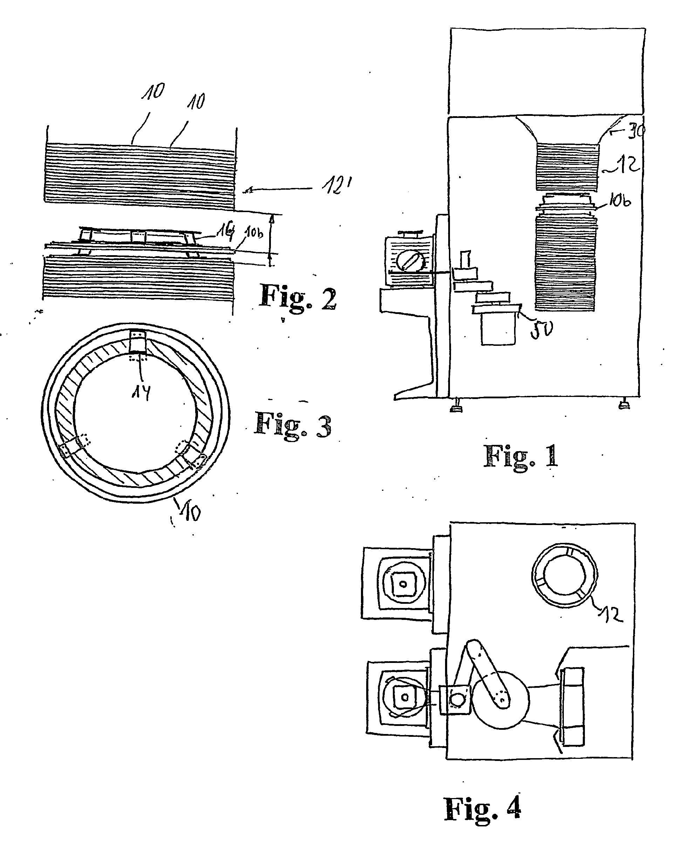

In einer in Fig. 1 als Ganzes mit 100 bezeichneten Vorrichtung ist ein Stapel 12 von Lagerungsringen 10 angeordnet, der unten aufliegt (nicht dargestellt). Mit Ausnahme des untersten Lagerungsring steht jeder Lagerungsringe 10 mit einem Stapelbereich unmittelbar auf dem jeweils unter ihm angeordneten Lagerungsring 10 auf. Von oben wird der Stapel 12 mit einer Reinluftanlage 20 so mit einem nach unten gerichteten Reinluftstrom durchströmt, dass im geschlossenen Zustand ein Reinraum ausgebildet wird. Im dargestellten geöffneten Zustand dient der Reinluftstrom, um innerhalb der Vorrichtung eine staub- und partikelfreie Umgebung zu erhalten.

Über ein Bedienpult 30 ist eine Handhabungseinrichtung 32 steuerbar, mit der der Stapel von Lagerungsringen selektiv geöffnet werden kann. Bei dem hier dargestellten Ausführungsbeispiel geschieht dies mit mittels einem auf die Vorrichtung abgestimmten Werkzeug 50.

In den Lagerungsringen 10 sind - wie in Fig. 3 dargestellt - drei Halterungselemente 16 (Auflager) angeordnet, auf denen ein scheibenförmiger Wafer 40 gelagert werden kann. Die Halterungselemente 16 sind leicht nach oben abgewinkelt und weisen nach innen (in Bezug auf die Lagerungsringe 10). Sie weisen jeweils eine ebene, leicht nach unten geneigte, Auflagefläche auf und bilden so eine Lagerungsstelle für einen Wafer 40 aus.

In Fig. 2 ist der geöffnete Zustand der Lagerungsringe 10 dargestellt. Dabei werden sämtliche Lagerungsringe oberhalb desjenigen Lagerungsringes, auf den ein Zugriff vorgesehen ist, um einen bestimmten Betrag nach oben angehoben. Hierdurch entsteht ein Zugriffsraum. Allerdings sind die Lagerungsringe 10 - und damit auch die Wafer - derart dicht gepackt, dass der vorgesehene Wafer noch nicht ohne weiteres untergriffen werden kann, da dieser zum nächst unteren Wafer einen sehr geringen Abstand aufweist. Aus diesem Grund wird der auf den angehobenen Teilstapel 12' nach unten folgende Lagerungsring - nachfolgend oder gleichzeitig - ebenfalls um einen bestimmten Betrag angehoben. Diese Hubhöhe kann beispielsweise der Höhe entsprechen, mit der die Wafer 40 durch die abgewinkelten Halterungselemente 16 nach oben vom ringförmigen Teils des Lagerungsrings beabstandet sind. Durch diese Massnahme ist trotz der im Lagerungszustand der Vorrichtung grosse Packungsdichte jeder Wafer gut zugänglich. Wie in Fig. 4 dargestellt ist, kann der entsprechende Wafer 40 nach seiner Entnahme durch einen Handhabungsautomaten einem weiteren Handhabungsvorgang oder Prozess zugeführt werden.

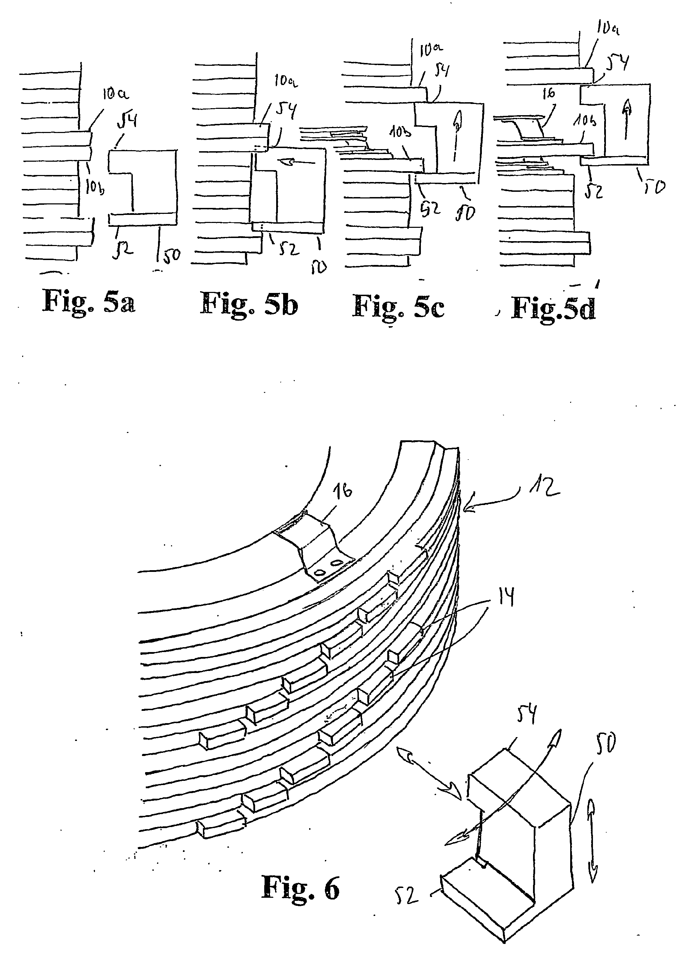

In den Fig. 5a bis 5d ist der oben beschriebene Öffnungsvorgang im Detail dargestellt. Das Werkzeug 50, das zwei Hebeflächen 52 und 54 aufweist, wird an einer bestimmten azimutalen Position auf den Stapel 12 von Lagerungsringen hin bewegt und greift dann mit der oberen Hebefläche unter den Lagerungsring 10a. Danach wird der Lagerungsring 10a um einen bestimmten Weg nach oben bewegt, bis die untere Hebefläche an den Lagerungsring 10b angreift. Dann wird der untere Lagerungsring 10b um einen wiederum bestimmten Weg angehoben, wobei alle darüber liegenden Lagerungsringe weiter mit angehoben werden. In dieser Position ist auf den Wafer, der auf dem Lagerungsring 10b aufliegt, frei von Elementen der Vorrichtung oder anderen Wafern, zugreifbar, wie dies aus Fig. 5d ersichtlich ist. Durch den Greifer 60 kann nun also dieser Wafer entnommen werden. Zum Einfügen eines Wafers in die Vorrichtung und dessen Ablage auf dem Lagerungsring 10b kann in Bezug auf die Erzeugung eines Zugriffsraums für den Lagerungsring 10b in prinzipiell gleicher Weise vorgegangen werden.

In der dargestellten Ausführungsform kann das Werkzeug 50 um den Stapel 12 der Lagerungselemente 10 herumgedreht werden, um jede beliebige Position am Umfang des Stapels einnehmen zu können. In einer anderen Ausführungsform ist es aber auch möglich, dass der Stapel 12 gedreht oder in sonstiger Weise bewegt wird und das Werkzeug in Bezug auf seine Position am Umfang des Stapels fest steht oder nur um einen kleinen Schwenkwinkel drehbar ist.

In der hier dargestellten erfindungsgemässen Ausgestaltung wird der Stapel 12 der Lagerungsringe 10 dadurch stabilisiert, dass seine Position aussen durch drei nicht näher dargestellte vertikale Stangen gehalten wird. Dies verhindert ein Kippen des Stapels 12. Alternativ hierzu kann zumindest ein Führungsstift vertikal durch die Lagerungselemente hindurchgeführt sein.

Wie in Fig. 6 gezeigt ist, sind die Vorsprünge 14 an den Lagerungsringen 10 treppenartig gegeneinander versetzt, so dass jeweils der Vorsprung des höheren Lagerungsringes beispielsweise im Uhrzeigersinn - azimutal (in Umfangsrichtung) um etwas mehr als die Breite des Vorsprunges versetzt ist. Die Massnahme steht mit der Ausgestaltung des Werkzeuges 50 dieses Ausführungsbeispiels in Verbindung, bei dem die untere Hebefläche 52 nach links gegenüber der oberen Hebefläche 54 um etwas mehr als eine Vorsprungsbreite versetzt ist.

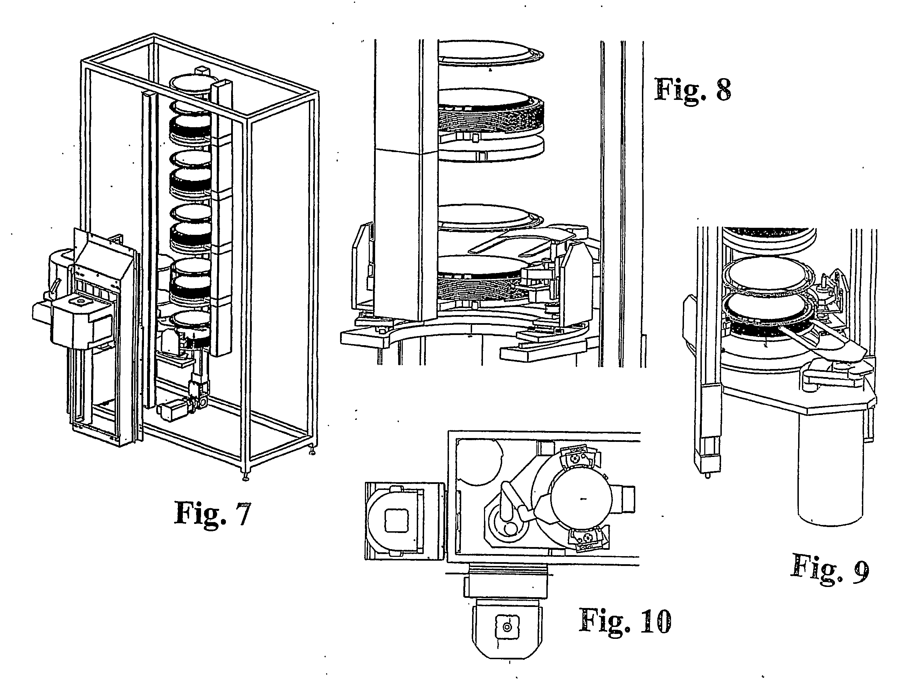

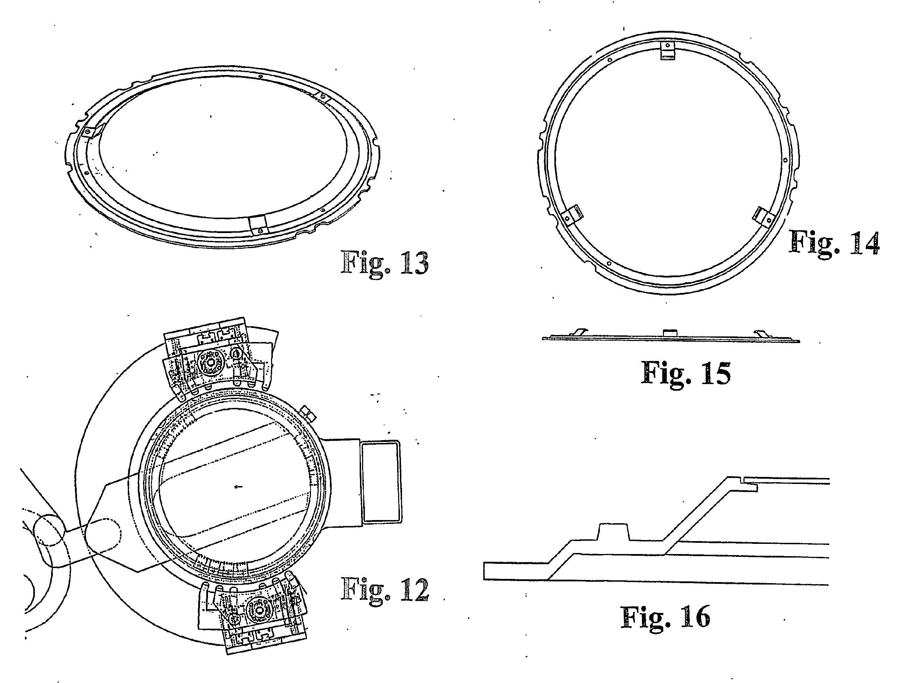

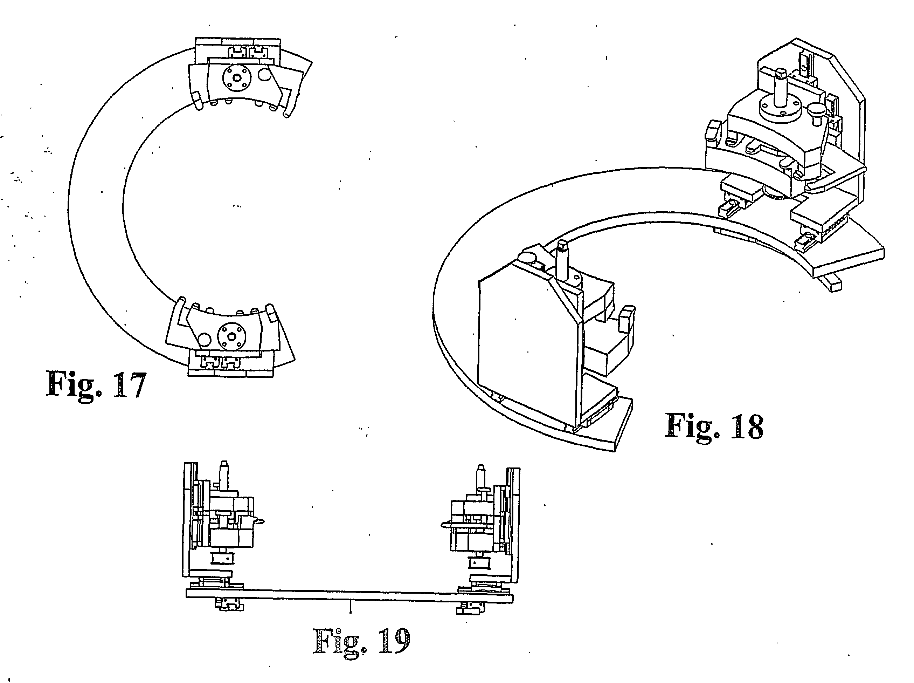

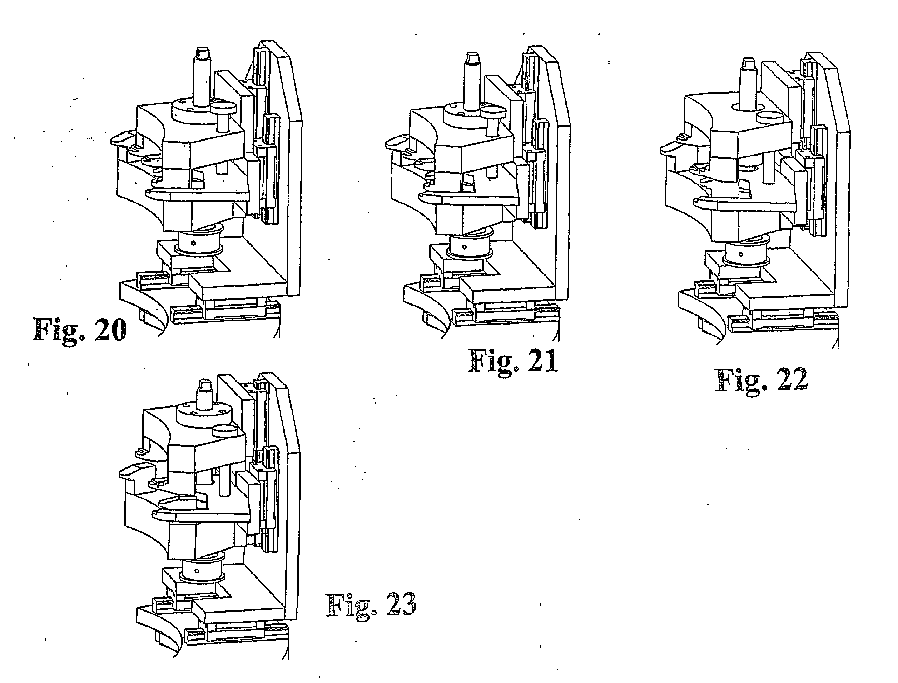

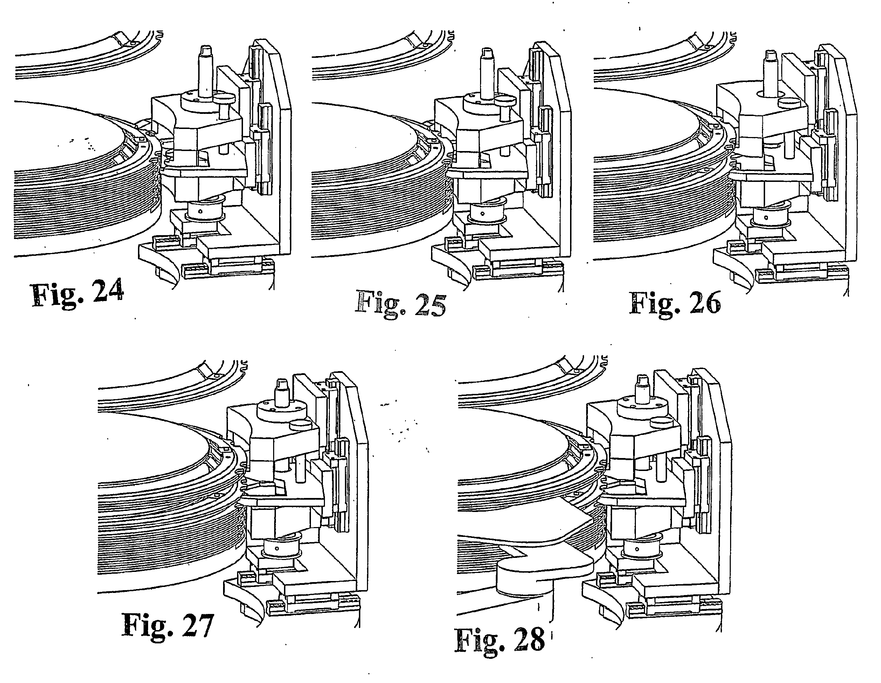

In einer bevorzugten Ausführungsform gemäss den Fig. 7 - 28 sind die seitlichen Führungen so angeordnet, dass ein Eingriff in den Stapel nicht nur zum Herausnehmen und Wiedereinsetzen von Wafern 40, sondern auch zum Austausch von Lagerungsringen 10 ermöglicht wird. Hierzu sind auf beiden Seiten der Lagerungsringe 10 weit auseinander liegende Führungselemente 80 angeordnet, die ein horizontales Herausziehen der Lagerungsringe 10 zulassen. Diese Führungselemente 80 sind im Ausführungsbeispiels mit Roll- oder Gleitelementen versehen. Bei einer solchen Vorrichtung ist es möglich, dass auch während des Betriebs der Anlage an dieser Wartungsarbeiten durchgeführt werden können, ohne dass die gesamte Anlage ausser Betrieb gesetzt werden müsste. Wartungsarbeiten können beispielsweise darin bestehen, Lagerungselemente auszutauschen, zu entfernen oder den Stapel mit zusätzlichen Lagerungselementen zu versehen.

In diesem Ausführungsbeispiel wird von der bereits erwähnten Spreizlösung Gebrauch gemacht. Dabei greift das Werkzeug der Vorrichtung in jeweils drei Lagerungsringe ein, also auch in den Lagerungsring 10c, der unterhalb des Lagerungsrings 10b angeordnet ist. Dieser Lagerungsring 10c wird dabei in seinem Niveau gehalten, so dass die - z.B. durch den Druck der Anordnung entstandene - Spannung bei Entlastung nicht zu einem selbständigen Anheben der unten verbleibenden Lagerungsringe führen kann.

Schliesslich sind auch erfindungsgemässe Ausführungsformen möglich, bei denen die Substrate nicht derart oder gar nicht verdichtet auf Lagerungselementen gespeichert werden, beispielsweise in dem als Standard vorgesehenen sogenannten "1/1 pitch". Hierdurch kann ein Zugriff auf ein Substrat möglich sein ohne einen Abstand zu einem oder mehreren benachbarten Lagerungselementen zu verändern. Trotzdem kann auch in einer solchen Anordnung das vorstehend beschriebene Spreizen zum Verhindern des selbständigen Anhebens der unten liegenden Lagerungselemente durchaus sinnvoll sein.

Um den Grad der Verdichtung auf besonders einfache Weise variieren zu können, kann jeweils zwischen zwei aufeinander folgenden Lagerungsringen ein in den Figuren nicht dargestellter Zwischenring angeordnet sein, gegen den die beiden jeweiligen Lagerungsringe anliegen. Über die Höhe der Lagerungsringe kann der Abstand aufeinander folgender Substrate innerhalb der Lagervorrichtung varriert werden. Trotz dieser Variationsmöglichkeit können stets die gleichen Lagerungselemente zum Einsatz kommen. Diese mögliche erfindungsgemässe Ausgestaltung zeigt auch auf, dass im Zusammenhang mit der Erfindung die Lagerungselemente nicht unbedingt unmittelbar aufeinander folgen müssen.

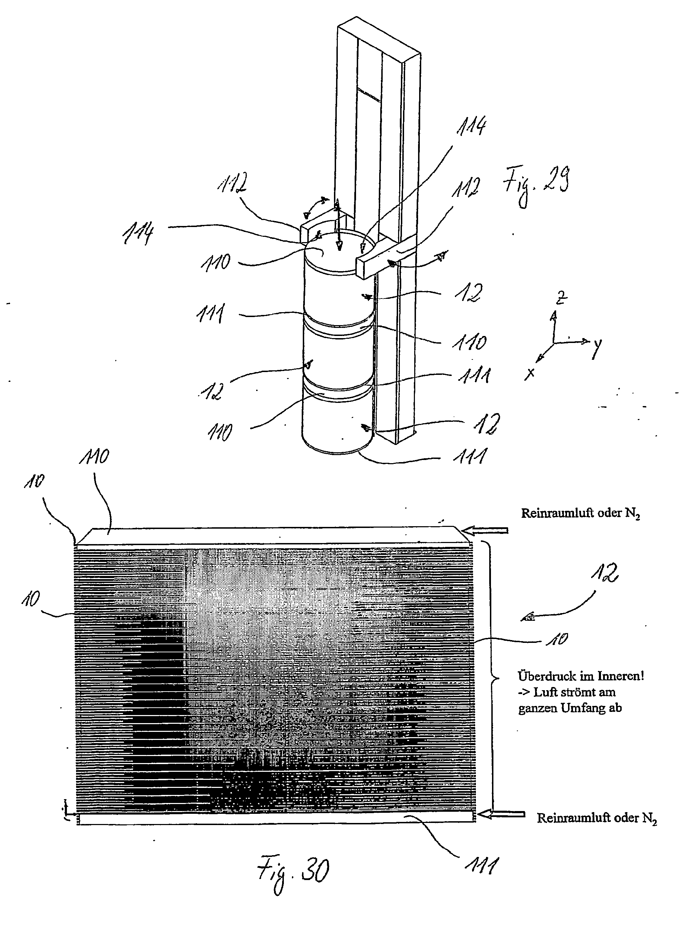

Bei der in Fig. 29 gezeigten erfindungsgemässen Ausführungsform sind mehrere Stapel 12 von Lagerungsringen 10 vorgesehen. In der Darstellung von Fig. 29 sind die einzelnen Lagerungsringe als solche nicht gezeigt, sondern nur ihre Gesamtheit in Form des jeweiligen Stapels 12. Auf jedem Stapel 12 ist ein oberer Abschlussdeckel 110 angeordnet, der beispielsweise auf dem obersten Lagerungsring aufsitzen kann (s. auch Fig. 30). Jeder der Stapel 12 kann zudem mit seinem jeweiligen unteren Lagerungsring auf einer unteren Bodenplatte 111 angeordnet sein. Die Lagerungselemente sowie die Bodenplatte 111 und der Abschlussdeckel 110 bilden einen insgesamt im wesentlichen geschlossenen Behälter aus.

Jede der Bodenplatten 111 ist an einer in Z-Richtung (d.h. vertikal) verfahrbaren Achse befestigt, wodurch sämtliche Lagerungsringe 10 unmittelbar zwischen zwei in Z-Richtung ortsfesten Armen 112 verfahrbar sind. Jeder der beiden Arme 112 enthält nachfolgend noch näher erörterte Öffnungswerkzeuge 114, mit denen der jeweilige Stapel 12 an jeder beliebigen Stelle für einen Zugriff auf ein bestimmtes Substrat oder einen bestimmten Lagerungsring 10 geöffnet werden kann. In einer anderen Ausgestaltung können die Öffnungswerkzeuge verfahrbar und der zumindest eine Stapel ortsfest angeordnet sein.

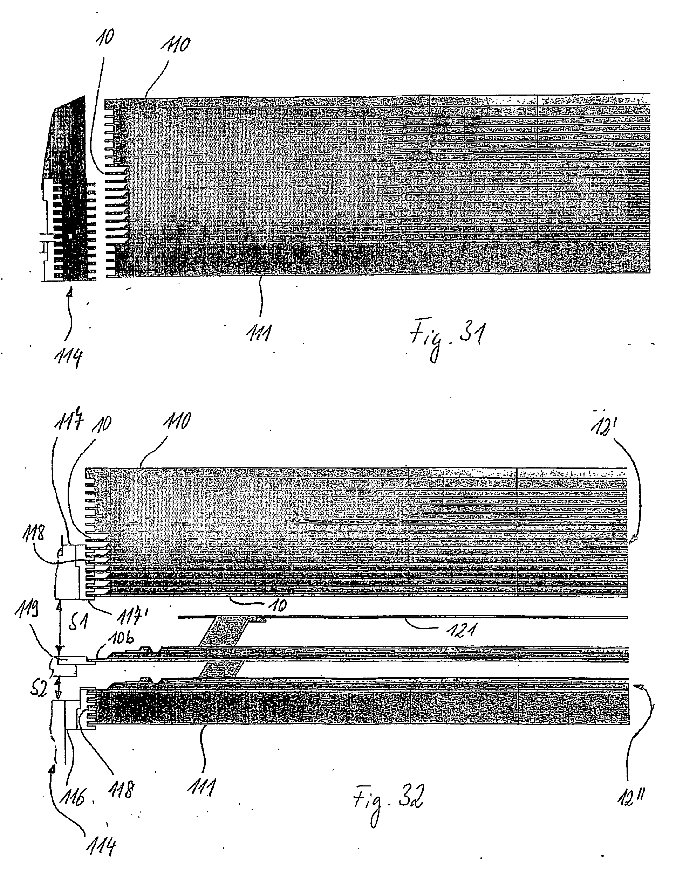

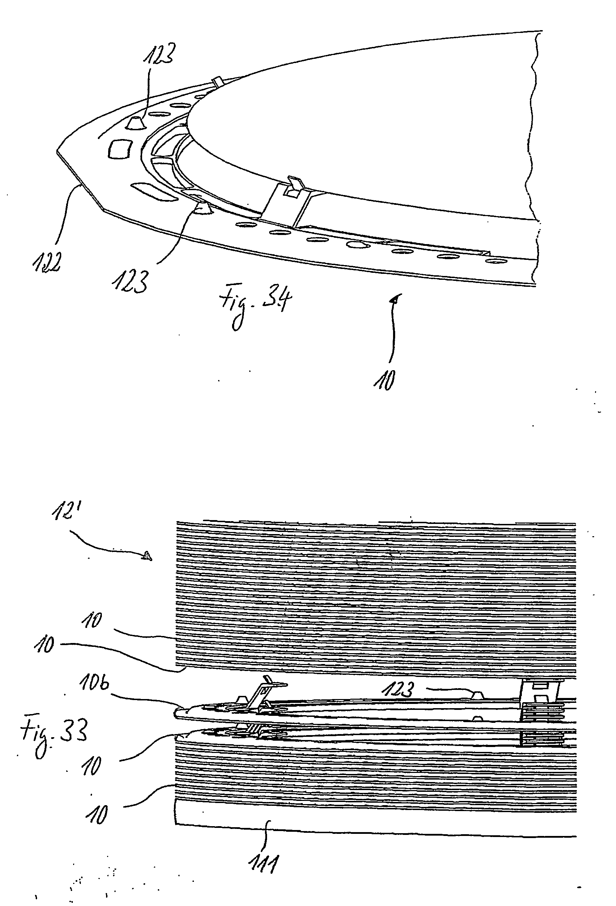

Anhand von Fig. 31 und 32 werden die beiden Öffnungswerkzeuge näher erläutert, von denen jeweils eines in einem der beiden parallel zur Ebene der Wafer schwenkbaren Arme 112 angeordnet ist. Wie insbesondere aus Fig. 32 ersichtlich ist, weist jedes Öffnungswerkzeug 114 einen unteren und einen oberen Greifteil 116, 117 auf. Der obere Greifteil 117 ist hierbei mit einer Mehrzahl von übereinander angeordneten Greifelementen 117' ausgebildet. Aufeinander folgende Greifelemente 117' bilden zwischen sich eine Nut 118 aus, deren Nutbreite grösser ist als die Höhe der in Fig. 33 in einer perspektivischen Ausschnittsdarstellung ebenfalls dargestellten Lagerringe 10 im Bereich ihres äusseren Umfangs. Da der Abstand aufeinander folgender Nuten 118 dem Abstand aufeinander folgender Lagerungsringe 10 entspricht, kann in jeder Nut 118 ein Lagerungsring mit einem Abschnitt seines Umfangsbereichs angeordnet werden.

Der untere Greifteil 116 ist in prinzipiell gleicher Weise ausgebildet, während ein mittlerer Greifteil 119 lediglich eine gestufte Auflagefläche aufweist.

Soll nun zur Entnahme oder zum Einsetzen eines Wafers auf einen bestimmten Lagerungsring 10 zugegriffen werden können, so werden zunächst sämtliche Stapel 12 (Fig. 29) gemeinsam in Z-Richtung verfahren. Hierdurch wird der für den Zugriff vorgesehene Lagerungsring 10b in Z-Richtung auf die gleiche Position gebracht, in der sich auch der mittlere Greifteil 119 befindet. Anschliessend können die beiden Arme 112 auf den Stapel 12 zugeschwenkt werden, so dass der Lagerungsring 10b mit einem Umfangsabschnitt unmittelbar über der Auflagefläche des mittleren Greifteils 119 befindet. Auf diesen Lagerungsring 10b nach oben folgende Lagerungsringe 10 sind hierbei in den Nuten des oberen Greifteils angeordnet, während sich nach unten folgende Lagerungsringe 10 in Nuten des unteren Greifteils 116 befinden.

Falls auf einen Lagerungsring 10 zugegriffen werden soll, der sich im Bereich der Bodenplatte 111 befindet, so kann auch die Bodenplatte 111 selbst mit ihren Stegen im unteren Greifteil 116 angeordnet sein, wie dies in Fig. 32 gezeigt ist. Gleiches gilt für den oberen Greifteil 117 und den Abschlussdeckel 112, der ebenfalls an seinem Umfang mit entsprechenden Stegen versehen ist.

Zur Erzeugung eines Zugriffsabstandes zwischen zwei aufeinander folgenden Lagerungsringen kann die hierfür erforderliche Relativbewegung nur in den Stapel, nur in das Öffnungswerkzeug oder jeweils eine Teilbewegung sowohl in den Stapel als auch in das Öffnungswerkzeug gelegt werden. In einer dieser möglichen Ausgestaltungen wird der obere Greifteil 117 um einen vorbestimmten geringen Weg S1 in Z-Richtung nach oben und der untere Greifteil 116 um einen ebenfalls vorbestimmten Weg S2 nach unten abgesenkt. Der Betrag des Weges S1 kann hierbei grösser sein als der Betrag des Weges S2. Der mittlere Greifteil 119 kann hingegen in seiner ursprünglichen Z-Position verbleiben. Als Ergebnis hiervon stellt sich eine Situation ein, wie sie in Fig. 32 gezeigt ist. Der zu entnehmende Wafer weist nun für eine Handhabung durch einen Handhabungsautomaten sowohl einen ausreichenden Abstand zum nächst höheren Lagerungsring 10 als auch zum nächst unteren Wafer auf. Der nächst untere Wafer kann sich nun in etwa in der Ebene des Lagerungsringes 10b befinden, auf dessen Wafer zugegriffen wird.

Da es zur Freistellung bzw. Trennung von Lagerungsringen 10 und deren Wafern im wesentlichen nur auf eine Relativbewegung zwischen dem freizustellenden Lagerungsring 10b und dem hierzu darüber - und/oder gegebenenfalls auch dem unter ihm - angeordneten Lagerungsring ankommt werden nachfolgend weitere mögliche Bewegungsverteilungen erläutert. Die Relativbewegung(en) können selbstverständlich auch auf weitere Weisen als hier dargestellt erzeugt werden.

So ist es beispielsweise möglich, dass der Teilstapel 12', der oberhalb dem Lagerungsring 10b angeordnet ist, auf den zugegriffen werden soll (oberer Teilstapel) während des Trennvorgangs in seiner momentanen Z-Position nur gehalten wird. Der Abstand zum oberen Teilstapel 12' wird durch eine in Z-Richtung nach unten gerichtete Verfahrbewegung des mittleren Greifteils 119 - und damit auch des Lagerungsringes 10b- sowie des unter ihm angeordneten unteren Teilstapels 12" erzeugt. Die Bewegung des mittleren Greifteils 119 kann beispielsweise dadurch gestoppt werden, dass er gegen einen Anschlag stösst. Der unterhalb des Lagerungsringes 10b angeordnete untere Teilstapel 12" kann hingegen mittels des unteren Greifteils 116 diese Bewegung fortsetzen, bis auch der untere Greifteil 116 gegen einen Anschlag stösst oder auf sonstige Weise seine Bewegung stoppt. Hierdurch ist auch unterhalb des auf dem Lagerungsring 10b angeordneten Substrates 121 genügend Raum, um einen Greifer zwischen das Substrat 121 und dem Lagerungsring 10b hineinzufahren.

In einer anderen Ausführungsform wird der obere Teilstapel 12' wiederum in seiner Z-Position durch den oberen Greifteil 117 positionsfest gehalten. Der Zugriffsraum wird durch eine in Z-Richtung nach unten gerichtete Bewegung der restlichen Lagerungselemente 10 geschaffen, in dem beispielsweise die Bodenplatte 111 nach unten gefahren wird. Durch eine unterschiedliche Begrenzung der Fahrwege des Lagerungsringes sowie des unteren Teilstapels kann auch zwischen diesen ein Abstand erzeugt werden.

Sämtliche in Z-Richtung nach unten oder oben gerichtete Bewegungen können ganz oder teilweise durch Ausnutzung der Schwerkraft und/oder durch Antriebsmittel wie beispielsweise hydraulische, pneumatische elektrische und federelastische Antriebsmittel ausgeführt werden. Derartige Antriebsmittel ermöglichen auch eine funktionssichere Schliessung der Lagervorrichtung nach einem Zugriff auf eines der Lagerungselemente.

Aus Fig. 33 und 34 sind weitere Details der im Zusammenhang mit diesen erfindungsgemässen Ausführungsbeispielen bevorzugt zum Einsatz kommenden Lagerungsringen 10 ersichtlich. Demnach sind die Lagerungsringe nur näherungsweise kreisrund. Sie weisen vielmehr vier um 90° zueinander versetzte und im wesentlichen geradlinig verlaufende Abschnitte 122 auf. Durch den geradlinigen Verlauf ist es möglich diese Abschnitte mit einer grösseren Kontaktfläche in den Nuten der Greifteile bzw. auf deren Auflageflächen anzuordnen.

Ausserdem weisen die Lagerungsringe mehrere Zentrierdome 123 auf, die dazu dienen, die Lagerungsringe 10 möglichst exakt aufeinander stapeln zu können. Hierbei greifen die Zentrierdome 123 in die jeweiligen Zentrierdome 123 eines in Stapelrichtung benachbarten Lagerungsringes 10 ein. Durch die Zentrierdome 123 lassen sich Mittel vermeiden, die sonst zusätzlich zu den Lagerungsringen für deren exakte Ausrichtung zueinander bzw. relativ zur Bodenplatte 111 erforderlich wären.

Innerhalb des sich aus zumindest den Lagerungsringen 10, der unteren Bodenplatte 111 sowie dem Abschlussdeckel 110 zusammengesetzten Lagerbehälters können Reinraumbedingungen erzeugt werden, wie dies in Fig. 30 angedeutet ist. Die hierfür vorgesehenen Mitteln zur Erzeugung von Reinraumbedingungen sind nicht näher dargestellt. Mit diesen Mitteln lässt sich im Inneren des Lagerbehälters eine gegenüber der Umgebung unter erhöhtem Druck stehende Atmosphäre schaffen, beispielsweise eine Stickstoff- oder Reinstluftatmosphäre. Mit vorbestimmten Undichtigkeiten des Lagerbehälters kann eine gezielte Abströmung des jeweiligen Gases aus dem Inneren des Lagerbehälters erreicht und das Eindringen von Partikeln von Aussen in das Innere des Behälters vermieden werden. Diese Undichtigkeiten können beispielsweise durch Weglassung einer Abdichtung oder durch eine unvollständige Abdichtung zwischen den Lagerungsringen erreicht werden.

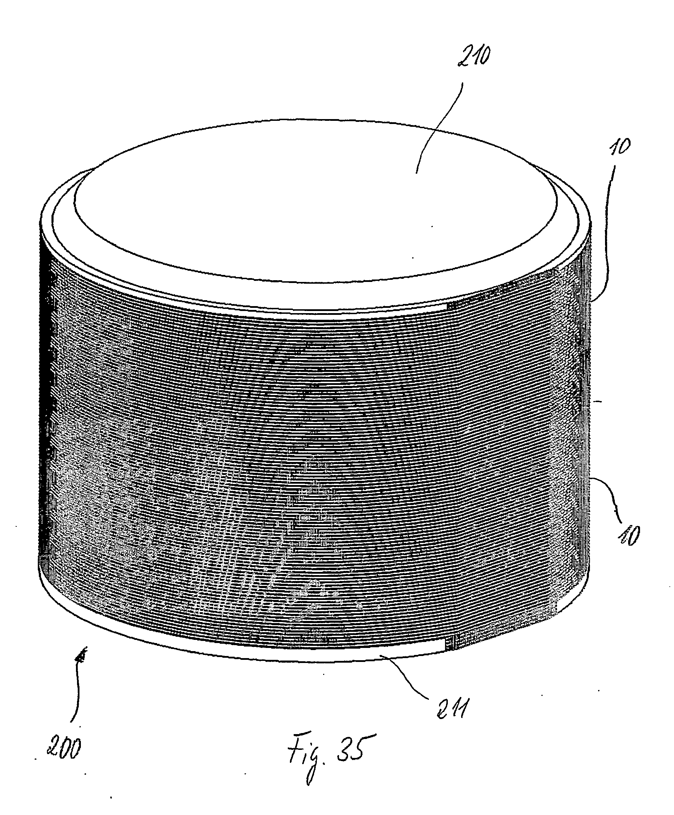

In Fig. 35 ist ein erfindungsgemässer Transportbehälter 200 gezeigt, der sich aus übereinander und unmittelbar aufeinander angeordneten Lagerungsringen 10, einer Bodenplatte 211 sowie einem Abschlussdeckel 210 zusammensetzt. Da die Lagerungsringe wiederum nicht dargestellte Dichtungselemente aufweisen bilden sie zusammen mit dem Abschlussdeckel und der Bodenplatte einen abgedichteten Transportbehälter 200 für Substrate. Mit Verschlussmittein, beispieslweise zwei nicht näher dargestellte Klammern, die jeweils sowohl den Abschlussdeckel 210 als auch die Bodenplatte 211 umgreifen, kann der Transportbehälter 200 gegen ein ungewolltes Öffnen gesichert werden. Aufeinander folgende Lagerungsringe 10 können in vorteilhaften Weiterbildungen der Erfindung in nicht näher dargestellten Weisen gegenseitig angelenkt sein. Hierdurch kann eine Vergrösserung des Abstandes von Lagerungselementen 10 auf besonders einfache Weise erreicht und gleichzeitig ein Zusammenhalt zwischen den Lagerungselementen geschaffen werden. Eine solche Anlenkung kann beispielsweise eine Art Scherenanlenkung sein.

In einer Weiterbildung der Erfindung kann auch vorgesehen sein, dass der dargestellte Transportbehälter 200 in eine äussere verschliessbare Transportbox eingesetzt wird. In diesem Fall können die Abdichtungen gegen äussere Einflüsse durch die äussere Transportbox stattfinden.

## Patentansprüche

1. Vorrichtung zum Lagern von plattenförmigen Substraten, insbesondere von Wafem- oder Testwafern (40), wie sie in der Fertigung von elektronischen Bauteilen vorkommen, wobei die Vorrichtung
• mehrere in einer Stapelrichtung aufeinander folgende Lagerungselemente (10) aufweist, die jeweils zur Aufnahme von zumindest einem Substrat vorgesehen sind,
• die Lagerungselemente (10) als in sich geschlossene Lagerungsringe (10) ausgebildet sind,
• die Lagerungselemente (10) jeweils mit Mitteln zur Auflage der Substrate versehen sind, die Mittel zur Auflage der Substrate als in Bezug auf die Lagerungsringe (10) nach innen und oben gerichtete Vorsprünge ausgebildet sind, durch die ein Substrat oberhalb eines Ringabschnitts des Lagerungselements auflegbar ist,
**dadurch gekennzeichnet, dass**
• die Lagerungselemente (10) direkt aufeinander stapelbar sind und hierzu einen Stapelbereich aufweisen, der zur Anordnung des jeweiligen Lagerungselements (10) innerhalb eines Stapels von Lagerungselementen (10) vorgesehen ist, und
• bei aufeinanderfolgenden Lagerungselementen (10) ihr jeweiliger Abstand von einem Lagerungsabstand zu einem hierzu vergrößerten Zugriffsabstand veränderbar ist.

2. Vorrichtung nach Anspruch 1, **dadurch gekennzeichnet, dass** die Lagerungselemente zur Erzeugung eines vergrösserten Abstandes von zwei aufeinanderfolgenden Lagerungselementen an ihrem Stapelbereich handhabbar sind, wodurch eines der Lagerungselemente für eine Ablage oder eine Entnahme eines Substrats zugänglich wird.

3. Vorrichtung nach zumindest einem der vorhergehenden Ansprüche, **dadurch gekennzeichnet, dass** zur Erzeugung eins vergrösserten Abstandes eine Relativbewegung zwischen den beiden Lagerungselementen ausführbar ist.

4. Vorrichtung nach zumindest einem der vorhergehenden Anspruche, **dadurch gekennzeichnet, dass** lagerungselemente aufeinander stapelbar sind, ohne dass sie lösbare oder unlösbare Verbindungen zueinander aufweisen.

5. Vorrichtung nach zumindest einem der vorhergehenden Ansprüche **dadurch gekennzeichnet, dass** die Vorsprünge eine horizontal ausgerichtete Auflagefläche aufweisen.

6. Vorrichtung nach zumindest einem der vorhergehenden Ansprüche, **dadurch gekennzeichnet, dass** aufeinander angeordnete Lagerungselemente einen zumindest seitlich, vorzugsweise vollständig, abgeschlossenen Raum ausbilden.

7. Vorrichtung nach Anspruch 6, **gekennzeichnet durch** Mittel zur Erzeugung von Reinluft, mit denen sich in dem abgeschlossenen Raum eine Reinraumatmosphäre erzeugen lässt.

8. Vorrichtung nach Anspruch 7, **dadurch gekennzeichnet, dass** sich mit den Reinraummitteln im Inneren der Vorrichtung ein Überdruck erzeugbar ist.

9. Vorrichtung nach Anspruch 6 oder 7, **gekennzeichnet durch** Mittel für eine vorbestimmte Abströmung eines Gases von innerhalb der Vorrichtung nach Aussen.

10. Vorrichtung nach zumindest einem der vorhergehenden Ansprüche, **gekennzeichnet durch** Mittel zur Erhöhung einer Kippsicherheit und/oder einer Positioniergenauigkeit von übereinander angeordneten Lagerungselemente.

11. Vorrichtung nach Anspruch 10, **gekennzeichnet, durch** zumindest ein an einem der Lagerungselemente ausgebildeten Zentriermittel, das jeweils mit einem Zentriermittel eines in Stapelrichtung nachfolgenden Lagerungselementes zur Erhöhung der Kippsicherheit zusammenwirkt.

12. Vorrichtung nach zumindest einem der vorhergehenden Ansprüche, **gekennzeichnet durch** ein Werkzeug zur Erzeugung einer Relativbewegung zwischen Lagerungselementen, das mit einer ersten Kontaktfläche zum Kontaktieren eines oberen Lagerungselements, sowie einer zweiten Kontaktfläche zum Kontaktieren eines unteren Lagerungselements versehen ist, wobei Bewegungsmittel vorgesehen sind, mit denen eine Relativbewegung zwischen zumindest einem der Lagerungselemente und zumindest einer der Kontaktflächen ausführbar ist, um einen Abstand zwischen den Lagerungselementen zu vergrössem.

13. Vorrichtung nach Anspruch 12, **dadurch gekennzeichnet, dass** die beiden Kontaktflächen des Werkzeuges in Stapelrichtung der Lagerungselemente zueinander versetzt sind.

14. Vorrichtung nach einem oder beiden der vorhergehenden Ansprüche 12 und 13, **gekennzeichnet durch** eine relative Verfahrbarkeit der beiden Kontaktflächen.

15. Vorrichtung nach zumindest einem der vorhergehenden Ansprüche, **dadurch gekennzeichnet, dass** das Werkzeug in einer Ebene parallel zu Oberflächen der scheibenförmigen Substraten beweglich ist.

16. Transportbehälter zum Transport von Substraten in einem verschliessbaren Raum, wobei der Transportbehälter Lagerungselemente aufweist, auf denen jeweils ein Substrat angeordnet werden kann, **gekennzeichnet durch** eine Vorrichtung nach zumindest einem der vorhergehenden Ansprüche 1 bis 12.

17. Verfahren zur Handhabung eines scheibenförmigen Substrats, insbesondere eines Wafers, wie er zur Herstellung von Halbleiterbauelementen vorgesehen ist, wobei zur Annäherung eines Werkzeugs (50, 114), das zwei Kontaktflächen aufweist, an ein bestimmtes Lagerungselement (10) innerhalb eines Stapels (12) von separierbaren Lagerungselementen (10), die als in sich geschlossenen Lagerungsringe ausgebildet sind und bei denen als Mittel zur Auflage der Substrate in Bezug auf die Lagerungsringe nach innen und oben gerichtete Vorsprünge ausgebildet sind, durch die ein Substrat oberhalb eines Ringabschnitts des Lagerungselements (10) flegbar ist, eine erste Relativbewegung ausgeführt wird, mit der die erste Kontaktfläche des bestimmten Lagerungselements (10) mit der zweiten Kontaktfläche des benachbarten Lagerungselements(10) jeweils direkt kontaktiert wird, nachfolgend eine zweite Relativbewegung ausgeführt wird, durch die mittels des Werkzeugs (50, 114) ein Abstand der beiden Lagerungselemente in Stapelrichtung vergrössert wird.

## Claims

1. A device for storing plate-shaped substrates, tin particular wafers or test wafers (40), as used in the fabrication of electronic components, wherein the device:
• comprises a plurality of storage elements (10) arranged consecutively in a stacking direction, each being provided to accommodate at least one substrate;
• the storage elements (10) are formed as complete storage rings (10);
• the storage elements (10) are each provided with means for supporting the substrates, the means for supporting the substrates being formed as projections which are orientated inwardly and upwardly with respect to the storage elements (10), by means of which a substrate can be supported above a ring section of the storage element:
**characterized in that**
• the storage elements (10) are capable of being stacked directly one non top of the other and for this purpose comprise a stacking region which is provided for arranging the respective storage element (10) in a stack of storage elements (10); and
• the respective separation of the consecutive storage elements (10) can be changed from a storage separation to a larger access separation.

2. The device as claimed in claim a, **characterized in that** the storage elements are capable of being manipulated in oder to produce a lager separation of two consecutive storage elements at their stacking region, whereupon one of the storage elements is made accessible for setting down or removing a substrate.

3. The device as claimed in at least one of the preceding claims, **characterized in that** a relative movement between the two storage elements is capable of being executed in order to produce a large separation.

4. The device as claimed in at least one of the preceding claims, **characterized in that** the storage elements are capable of being stacked one on top of the other without them having any releasable or non-releasable connections to each other.

5. The device as claimed in at least one of the preceding claims, 1 **characterised in that** the projections are provided with a horizontally orientated supporting surface.

6. The device as claimed in at least one of the preceding claims, **characterized in that** consecutively arranged storage elements form an at least laterally, preferably completely enclosed space.

7. The device as claimed in claim 6, **characterized by** means for producing clean air with which a clean air atmosphere can be produced in the enclosed space.

8. The device as claimed in claim 7, **characterized in that** the clean room means can be used to product an overpressure inside the device.

9. The device as claimed in claim 6 or claim 7, **characterized by** means for producing a predetermined outflow of a gas from within the device to the outside.

10. The device as claimed in at least one of the preceding claims, **characterized by** means for increaeing tilt resistance and/or positioning accuracy of consecutively arranged storage

11. The device as claimed in claim 10, **characterized by** at least one centring means formed on one of the storage elements which respectively cooperate with a centring means of an adjacent storage element in the stacking direction in order to increase the tilt resistance.

12. The device as claimed in at least one of the preceding claims, **characterized by** a tool for producing a relative movement between storage elements which is provided with a first contact surface for making contact with an upper storage element as well as with a second contact surface for making contact with a lower storage element, wherein movement means are provided by means of which a relative, movement between at least one of the storage elements and at least one of the contact surfaces can be executed in order to increase a separation between the storage elements.

13. The device as claimed in claim 12, **characterized in that** the two contact surfaces of the tool are offset with respect to each other in the stacking direction of the storage elements.

14. The device as claimed in one or both of the preceding claims 12 and 13, **characterized by** a relative displaceability of the two contact surfaces.

15. The device as claimed in at least one of the preceding claims, **characterised in that** the tool is movable in a plane parallel to the upper surface of the disc-shaped substrates.

16. A Transport container for transporting substrates in an enclosable space, wherein the transport container comprises storage elements on which a substrate can respectively be arranged, **characterized by** a device as claimed in at least one of the preceding claims 1 to 12.

17. A method for manipulating a disc-shaped substrate, in particular a wafer, as used in the fabrication of semiconductor components wherein, in order to bring a tool (50, 114) which comprises two contact surfaces close to a specific storage element (10) within a stack (12) of separable storage elements (10) which are formed as enclosed storage rings and which are provided with projections which project inwardly and upwardly with respect to the storage rings two act as a means for supporting the substrate, by means of which a substrate can be positioned above a ring section of the storage element (10), a first relative movement is executed, whereby the first contact surface of the specific storage element (10) is brought into direct contact with the second contact surface of the adjacent storage element (10), and then a second relative movement is executed whereby a separation of the two storage elements is increased in the stacking direction by means of the tool (50, 114).

## Revendications

1. Dispositif destiné au stockage de substrats en forme de disques, en particulier de galettes ou galettes de contrôle (40), telles qu'elles se présentent dans la fabrication des composants électroniques, pour lequel ledit dispositif
• présenté plusieurs éléments de stockage (10) successifs dans un sens d'empilage, qui sont: prévus respectivement pour recevoir au moins un substrat,
• les éléments de stockage (10) sont constitués comme des anneaux de stockage (10) se fermant sur eux-mêmes,
• les éléments de stockage (10) sont respectivement munis de moyens pour poser les substrats, les moyens pour poser les substrats sont constitués comme des parties en saillie orientées vers l'intérieur et vers le haut en référence aux anneaux de stockage (10), à travers lesquelles un substrat peut être posé au-dessus d'une section annulaire de l'élément de stockage,
**caractérisé en ce que**
• les éléments de stockage (10) sont directement empilables les uns sur les autres et présentent à cet effet une zone d'empilage qui est prévue pour ranger l'élément de stockage (10) respectif à l'intérieur d'une pile d'éléments de stockage (10), et
• leur espacement respectif est modifiable pour des éléments de stockage (10) successifs, d'un espacement de stockage en un espacement d'accès agrandi à cet effet.

2. Dispositif selon la revendication 1, **caractérisé en ce que** les éléments de stockage peuvent être manipulés sur leur zone d'empilage pour générer un espacement agrandi de deux éléments de stockage successifs, un des éléments de stockage étant de ce fait accessible pour la dépose ou l'enlèvement d'un substrat.

3. Dispositif selon une quelconque au moins des revendication précédentes, **caractérisé en ce que** pour créer un espacement agrandi, on peut exécuter un mouvement relatif entre les deux éléments de stockage.

4. Dispositif selon une quelconque au moins des revendications précédentes, **caractérisé en ce que** les éléments de stockage peuvent être empilés les uns sur les autres sans présenter de liaisons détachables ou non détachables les unes avec les autres.

5. Dispositif selon une quelconque au moins des revendications précédentes, **caractérisé en ce que** les parties en saillie présentent une surface d'appui orientée horizontalement.

6. Dispositif selon une quelconque au moins des revendications précédentes, **caractérisé en ce que** les éléments de stockage disposés les uns sur les autres constituent un espace fermés au moins latéralement, de préférence complètement.

7. Dispositif selon la revendication 6, **caractérisé par** des moyens destinés à créer de l'air pur avec lequel on peut produire une atmosphère de salle blanche dans l'espace fermé.

8. Dispositif selon la revendication 7, **caractérisé en ce qu'**une surpression peut être produite à l'intérieur du dispositif avec les moyens de salle blanche.

9. Dispositif selon la revendication 6 ou 7, **caractérisé par** des moyens destinés à faire écouler de façon prédéfinie un gaz de l'intérieur du dispositif vers l'extérieur.

10. Dispositif selon une quelconque au moins des revendications précédentes, **caractérisé par** des moyens destinés à augmenter une résistance au renversement et/ou une précision de positionnement des éléments de stockage disposés les uns sur les autres.

11. Dispositif selon la revendication 10, **caractérisé par** au moins un moyen de centrage constitué sur un des éléments de stockage, qui coopère respectivement avec un moyen de centrage d'un élément de stockage suivant dans le sens d'empilage pour augmenter la résistance au renversement.

12. Dispositif selon une quelconque au moins des revendications précédentes, **caractérisé par** un outil destiné à générer un mouvement relatif entre les éléments de stockage, qui est muni d'une première surface de contact pour mettre en contact un élément de stockage supérieur, ainsi que d'une deuxième surface de contact pour mettre en contact un élément de stockage inférieur, pour lequel des moyens de déplacement sont prévus avec lesquels on peut exécuter un mouvement relatif entre au moins un des éléments de stockage et au moins une des surfaces de contact pour agrandir un espacement entre les éléments de stockage.

13. Dispositif selon la revendication 12, **caractérisé en ce que** les deux surfaces de contact de l'outil sont déportées l'une par rapport à l'autre dans le sens d'empilage des éléments de stockage.

14. Dispositif selon une ou les deux revendications précédentes 12 et 13, **caractérisé par** une mobilité relative des deux surfaces de contact.

15. Dispositif selon une quelconque au moins des revendications précédentes, **caractérisé en ce que** l'outil est mobile dans un plan parallèlement aux surfaces des substrats en forme de disques.

16. Conteneur de transport pour le transport de substrats dans un espace fermable, ledit conteneur de transport présentant des éléments de stockage sur lesquels un substrat peut être à chaque fois disposé, **caractérisé par** un dispositif selon au moins une quelconque des revendications précédentes 1 à 12.

17. Procédé pour la manipulation d'un substrat en forme de disque, en particulier d'une galette, telle qu'elle est prévue pour la fabrication de composants à semi-conducteurs, pour lequel, pour l'approche d'un outil (50, 114) présentant deux surfaces de contact, sur un certain élément de stockage (10) à l'intérieur d'une pile (12) d'éléments de stockage (10) séparés, constitués comme des anneaux de stockage se fermant sur eux-mêmes, et, pour lesquels des parties en saillie orientées vers l'intérieur et vers le haut constituées en tant que moyens pour déposer des substrats en référence aux anneaux de stockage, à travers lesquels un substrat peut être déposé au-dessus d'une section annulaire de l'élément de stockage (10), un premier mouvement relatif est exécuté, avec lequel la première surface de contact du certain élément de stockage (10) est mise à chaque fois directement en contact avec la deuxième surface de contact de l'élément de stockage (10) voisin, un deuxième mouvement relatif est ensuite exécuté, par lequel un espacement entre les deux éléments de stockage est agrandi dans le sens d'empilage au moyen de l'outil (50, 114).
